Europäisches Patentamt

European Patent Office

Office européen des brevets

(11) Veröffentlichungsnummer: **0 380 819**

**A1**

(12) **EUROPÄISCHE PATENTANMELDUNG**

(21) Anmeldenummer: **89200357.5**

(22) Anmeldetag: **01.02.89**

(51) Int. Cl.⁵: **H03G 3/00, H04M 1/57**

(30) Priorität: **02.02.88 AT 207/88**

(43) Veröffentlichungstag der Anmeldung:
**08.08.90 Patentblatt 90/32**

(84) Benannte Vertragsstaaten:
**ES GR**

(71) Anmelder: **Siemens Aktiengesellschaft**
**Wittelsbacherplatz 2**
**D-8000 München 2(DE)**

(72) Erfinder: **Wurmitzer, Armin**
**Kainachgasse 19/5/12**
**A-1210 Wien(AT)**
Erfinder: **Formanek, Karl**
**Simmeringer Hauptstrasse 16/4/11**
**A-1110 Wien(AT)**

(54) **Schaltungsanordnung mit stellbaren aktiven und bzw. oder passiven Bauteilen.**

(57) Schaltungsanordnung mit stellbaren Verstärkern für Mikrofone, Hörer, Lautsprecher, Wahlsignalgeber oder stellbaren Widerständen für Impedanzanpassung, Filterfunktionen, Einrichtungen zur Frequenzkorrektur od. dgl., in Anwendung bei Fernsprechgeräten und Fernsprechanlagen bzw. -geräten, die an Fernsprechleitungen od. dgl. angeschaltet betrieben werden, mit stellbaren Verstärkern und passiven Bauelementen, die in Abhängigkeit von binär codierten Stellwert-Datenworten digital einstellbar sind. Die Stellwert-Datenworte sind in zugeordnete, über die Sprechadern (1,2) mit Strom versorgte Stellwert-Zwischenspeicher (6',12',13'...) einlesbar und dort flüchtig oder nichtflüchtig speicherbar. Alle Stellwert-Zwischenspeicher (6',12',13 ...) sind an zugeordnete Speicherplätze eines nichtflüchtigen Zentralspeichers (7) angeschlossen oder selbst als Bestandteile eines solchen ausgebildet, in den die für die einzelnen Zwischenspeicher (6',12',13'...) vorgesehenen Stellwert- Datenworte aus einem externen Datengeber mittels eines seriellen Datenbusses (39) einlesbar sind. Alle stellbaren Verstärker (19,27,37) und Widerstände (6,12,13...) samt ihren zugeordneten Zwischenspeichern (6',12',13'...) mit ihrer aus den Sprechadern (1,2) gespeisten Stromversorgungseinrichtung (9) sowie entweder der Zentralspeicher (7) selbst oder die Anschlüsse für einen externen Zentralspeicher mit allen Verbindungsleitungen (18,32) und Umschalteeinrichtungen (25,31) sind in einem einzigen in integrierter Schaltkreistechnik ausgeführten Bauteil zusammengefaßt.

**EP 0 380 819 A1**

## Schaltungsanordnung mit stellbaren aktiven und bzw. oder passiven Bauteilen

Die Erfindung betrifft eine Schaltungsanordnung mit stellbaren Verstärkern für Mikrofone, Hörer, Lautsprecher, Wahlsignalgeber od. dgl. und bzw. oder stellbaren oder simulierten Widerständen für Impedanzanpassung, Filterfunktionen, Einrichtungen zur Frequenzkorrektur oder zur Driftkompensation od. dgl., in Anwendung bei Fernsprechgeräten und Fernsprechanlagen bzw. - geräten, die an Fernsprechleitungen od. dgl. angeschaltet betrieben werden, mit stellbaren Verstärkern und passiven Bauelementen, die in Abhängigkeit von binär codierten Stellwert-Datenworten digital einstellbar sind.

Einrichtungen der genannten Art befinden sich nicht nur in Fernsprechteilnehmerstationen oder in Fernsprechvermittlungsanlagen, sondern auch bei wechselsprechanlagen, Fernüberwachungssystemen und überhaupt bei allen Anlagen, bei denen akustische Signale erzeugt, empfangen, übertragen und ausgesendet werden.

So sind beispielsweise zur optimalen Anpassung der elektrischen Betriebswerte einer Fernsprechteilnehmerstation an gegebene oder gewünschte Betriebsbedingungen, wie z.B. die Anpassung des Abschlußwiderstandes an die jeweilige Leitungslänge oder die Einstellung der gewünschten Hörer- oder weckerlautstärke, in den Fernsprechgeräten diverse Stelleinrichtungen vorgesehen, von denen jede für sich einzeln einstellbar ist.

Stelleinrichtungen ähnlicher Art sind aber auch im Zusammenhang mit Hörgeräten bekannt geworden, beispielsweise durch die AT-PS 379.929 und durch die DE-OS 3 642 828, bei denen die Verstärker von in digitalen Speichern gespeicherten Größen gesteuert sind. In beiden Fällen sind Fernsteuergeräte vorgesehen, die mittels akustischer Signale die Speicherinhalte der digitalen Speicher und damit die Verstärkungsgrade der Verstärker beeinflussen.

Im Zuge der Ausstattung der Fernsprechgeräte oder jener Einrichtungen, die mit Mikrofonen, Hörern od. dgl. versehen sind, mit elektronischen Bauteilen stellt sich die Frage, bei welchen Bauteilen die herkömmliche Bauweise beibehalten werden soll und welche Bauteile zu einem einzigen, in integrierter Schaltkreistechnik ausgeführten, universell verwendbaren Bauteil zusammengefaßt werden können. Hierbei spielt nicht nur der technische Aufwand eine Rolle, sondern auch die Wirtschaftlichkeit der Ausführung.

Die Erfindung hat sich daher die Aufgabe gestellt, eine in dieser Hinsicht optimale Lösung zu finden, die dadurch erzielt wird, daß die stellbaren Verstärker und Widerstände in Abhängigkeit von binär codierten Stellwert-Datenworten digital einstellbar sind, die in zugeordnete, über die Sprechadern mit Strom versorgte Stellwert-Zwischenspeicher einlesbar und dort flüchtig oder nicht flüchtig speicherbar sind und daß alle Stellwert-Zwischenspeicher an zugeordnete Speicherplätze eines nichtflüchtigen Zentralspeichers angeschlossen oder selbst als Bestandteile des nichtflüchtigen Zentralspeichers ausgebildet sind, in den die für die einzelnen Zwischenspeicher vorgesehenen Stellwert-Datenworte aus einem externen Datengeber mittels eines seriellen Datenbusses einlesbar sind und daß alle stellbaren Verstärker und Widerstände samt ihren zugeordneten Zwischenspeichern mit ihrer aus den Sprechadern gespeisten Stromversorgungseinrichtung sowie entweder der Zentralspeicher selbst oder die Anschlüsse für einen externen Zentralspeicher mit allen Verbindungsleitungen und Umschalteeinrichtungen in einem einzigen in integrierter Schaltkreistechnik ausgeführten Bauteil zusammengefaßt sind.

Die Erfindung macht sich einerseits den Umstand zunutze, daß bis auf jene Bauteile wie Mikrofone, Hörer, Wahlsignalgeber usw., die aus Gründen der Handhabung nicht beliebig in Miniatur ausgeführt werden können, alle Bauteile in einem einzigen Bauteil in integrierter Schaltkreistechnik zusammengefaßt sind.

Damit ergibt sich eine für eine effiziente Fertigung wesentliche Reduktion an diskreten Bauteilen. Anderseits bringt die Verwendung billiger flüchtiger Speicher als Zwischenspeicher, deren gespeicherten Datenworte im stromlosen Zustand zwar gelöscht, jedoch vor jeder Inbetriebnahme aus dem gemeinsaren Zentralspeicher wieder eingeschrieben werden eine wesentliche Verbilligung der ganzen Anordnung.

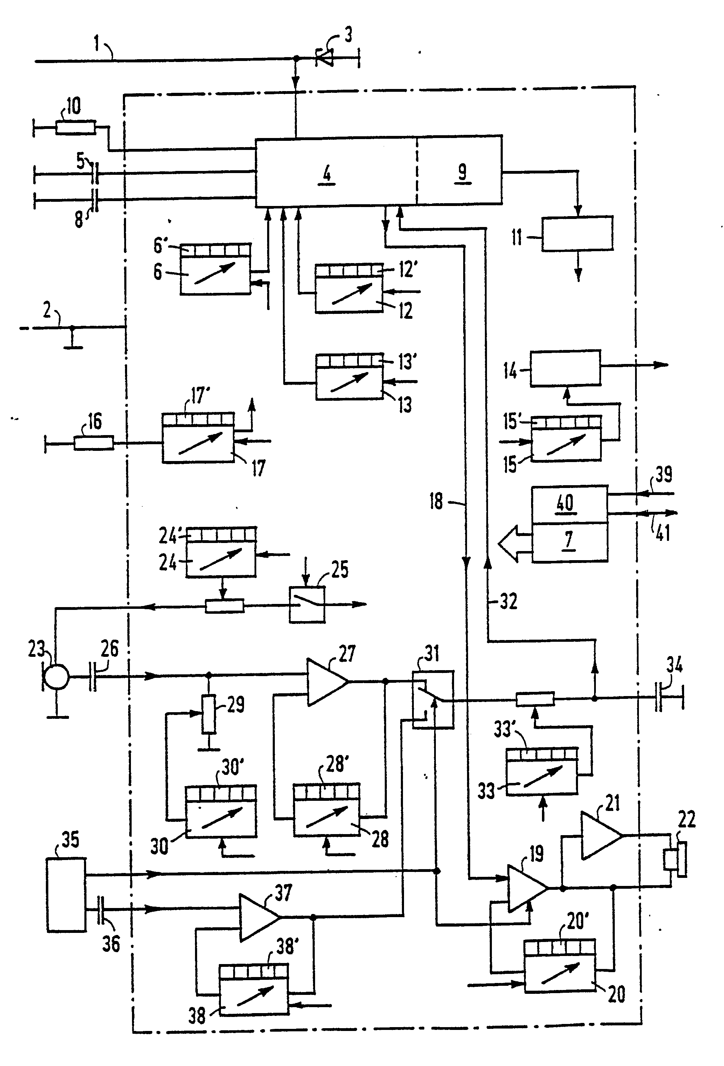

Als Ausführungsbeispiel der Erfindung sind in der Zeichnung die Bauteile einer Fernsprechteilnehmerstelle dargestellt, wobei jene Bauteile, die gemeinsam zu einem in integrierter Schaltkreistechnik ausgeführten Bauteil zusammengefaßt sind, durch strichpunktierte Linien von den anderen Bauteilen abgegrenzt sind.

Die in der Zeichnung dargestellte Fernsprechteilnehmerstelle ist mittels ihrer Sprechadern 1,2 mit ihrem zugeordneten Verbindungssatz verbunden, wobei die Sprechader 2 zugleich auch am Massepotential liegt. Über die Sprechadern erhält und sendet die Teilnehmerstelle nicht nur die Sprachinformationen, sondern bezieht über diese auch den Speisestrom für alle ihre Bauteile. Mittels einer Zenerdiode 3 ist die Spannung an der Ader 1 begrenzt, beispielsweise auf + 18 V. Mit 4 ist eine Gabelschaltung bezeichnet, die einerseits den Leitungsabschluß für die Sprechadern 1,2 bildet und anderseits die Auskopplung der ankommenden Sprachsignale und die Einkopplung der abgehenden Sprachsignale bewirkt.

Mit 5 ist ein Nachbildungskondensator bezeichnet, der einen Teil einer stellbaren Nachbildungsschaltung bildet, die mit Hilfe einer Stelleinrichtung 6 eine Optimierung der Leitungsabschlußimpedanz ermöglicht, die bekanntlich von der jeweiligen Leitungslänge abhängig ist. Die Stelleinrichtung 6 ist ebenso wie alle übrigen Stelleinrichtungen mit einem zugeordneten flüchtigen oder nichtflüchtigen Stellwert-Zwischenspeicher 6' versehen, der während des Betriebes der Anlage von einem nicht flüchtigen Zentralspeicher 7 ein binär codiertes Datenwort eingeprägt erhält, oder als Bestandteil des nichtflüchtigen Zentralspeichers ein Datenwort gespeichert hat, das den jeweils geltenden Stellwert repräsentiert. Im Falle der Stelleinrichtung 6 bezeichnet dieser Stellwert einen Widerstandswert eines in der Gabelschaltung 4 befindlichen, nicht näher dargestellten ohmschen Widerstandes, der mit dem Kondensator 5 zusammenwirkend die Abschlußimpedanz der Sprechadern 1,2 bildet. Die Verbindungen vom Zentralspeicher 7 zu den einzelnen Stelleinrichtungen ist einerseits durch einen vom Zentralspeicher 7 ausgehenden Pfeil und anderseits durch je einen zu jeder einzelnen Stelleinrichtung hinweisenden Pfeil symbolisiert. Ein weiterer Kondensator 8 dient zur Abgleichung zwecks Optimierung des Sprachwechselstromes.

Für die Stromversorgung der im integrierten Bauteil befindlichen Bauelemente sowie der angeschlossenen Bauteile dient ein Spannungs- Versorgungsgerät 9, das seine Energie über die Sprechadern 1,2 bezieht und eine Arbeitskennlinie aufweist, die den Vorschriften verschiedener Postverwaltungen hinsichtlich seines Energiebedarfes anpaßbar ist. Hierzu ist eine Messung des Strombedarfes erforderlich, der mittels eines Strommeßwiderstandes 10 gemessen wird. Für verschiedene Einrichtungen innerhalb des integrierten Bauteiles ist das Vorhandensein einer temperaturstabilisierten Spannung erforderlich, die von einem Stabilisator 11 geliefert wird. Zur Einstellung der jeweils geforderten Arbeitskennlinie dient ein Stellglied 12 mit einem zugeordneten Stellwert-Zwischenspeicher 12' Ein weiteres Stellglied 13 mit zugeordnetem Zwischenspeicher 13' dient zur Einstellung des erwähnten in der Gabelschaltung 4 befindlichen Leitungs-Nachbildung, mit deren Hilfe auch das Mithören der eigenen Sprache des Fernsprechteilnehmers einstellbar ist. Wenn der Strombedarf der an den integrierten Bauteil angeschlossenen Geräte einen vorgegebenen Schwellwert überschreitet, wird mittels eines Signalgebers 14 ein Warnsignal ausgelöst. Der hierzu vorgegebene Schwellwert wird von einem Stellglied 15 mit zugeordnetem Zwischenspeicher 15' geliefert.

Während bisher alle Stellglieder, die im Zusammenhang mit der Stromversorgung und der Leitungsanpassung verwendet werden, erwähnt wurden, werden in folgenden jene Stellglieder beschrieben, die im Zusammenhang mit stellbaren Verstärkern stehen, die für die Einstellung der Ströme des Mikrofons, des Hörers und der Wahleinrichtung vorgesehen sind. Für alle im folgenden erwähnten Verstärker ist eine Temperaturkompensation vorgesehen, für die mittels eines Widerstandes 16 im Zusammenwirken mit einem Stellglied 17 mit zugeordnetem Zwischenspeicher 17' ein Temperaturkompensationsstrom erzeugt wird, der allen diesen Verstärkern zugeführt wird.

Ein über die Sprechadern 1,2 ankommendes Sprachsignal wird von der Gabelschaltung 4 über eine Leitung 18 einem Verstärker 19 zugeführt, dessen Verstärkungsgrad mittels eines Stellgliedes mit zugeordnetem Zwischenspeicher 20' einstellbar ist. Die Ausgangsspannung des Verstärkers 19 wird über einen nachgeschalteten Verstärker 21 invertiert. An dem damit gebildeten Brückenverstärker sind Schallgeber 22 wie Hörkapseln, Lautsprecher etc. anschließbar.

Das für den abgehenden Sprechverkehr vorgesehene Mikrofon ist mit 23 bezeichnet. Zur Einstellung des Mikrofonstromes dient ein Stellglied 24 mit zugeordnetem Zwischenspeicher 24'. Im Mikrofonstromkreis ist zusätzlich noch ein Schalter 25 eingeschaltet, der während der Mehrfrequenzwahl geöffnet ist. Der Mikrofonstrom wird über einen Kondensator 26 in den integrierten Bauteil eingekoppelt und dort einem Mikrofonverstärker 27 zugeführt. Dieser ist mit einem Stellglied 28 zur Verstärkungseinstellung versehen, dem ein Zwischenspeicher 28' zugeordnet ist. Zur Einstellung des Frequenzganges des Mikrofonverstärkers ist ein Potentiometer 29 mit einem an seinen Abgriff geschalteten weiteren Stellgliedes 30 mit zugeordnetem Zwischenspeicher 30' vorgesehen. Der Ausgangsstrom des Mikrofonverstärkers 27 gelangt über einen Umschalter 31 sowie über eine Leitung 32 zur Gabelschaltung 4, wo das abgehende Sprachsignal in die Sprechadern 1,2 eingekoppelt wird. Einer zusätzlichen Modifizierung des abgehenden Sprachsignales dient ein weiteres Stellglied 33 mit zugeordnetem Zwischenspeicher 33', das zusammen mit einem extern angeschalteten Kondensator 34 ein RC- Glied bildet.

Die Wahlsignale werden mittels eines Mehrfrequenz-Wahlsignalgebers 35 erzeugt. Bei Betätigung des Wahlsignalgebers 35 wird zuerst der Umschalter 31 aus der gezeichneten Lage in die andere umgestellt, so daß die über einen Kondensator 36 übertragenen, sowie über einen Wahlsignalverstärker 37 verstärkten Wahlsignale anstelle der Mikrofonsignale an die zur Gabelschaltung 4 führende Leitung 32 gelangen. Der Wahlsignalverstärker 37 ist in seinem Verstärkungsgrad mittels eines Stellgliedes 38 verstellbar, dessen zugeordneter Zwischenspeicher mit 38' bezeichnet ist. Damit ist der Pegel der Wahlsignale einstellbar.

Im gezeigten Ausführungsbeispiel dient als Zentralspeicher entweder ein EAROM-Speicher (Electrical Alternating Read Only Memory) oder ein EEROM-Speicher (Electrical Erasible Read Only Memory). Die

3

den einzelnen Zwischenspeichern zugeordneten Speicherplätze des Zentralspeichers 7 werden mittels eines seriellen Datenbusses 39 durch ein externes Gerät mit den entsprechenden Daten belegt. Hierzu dient eine dem Zentralspeicher 7 vorgeschaltete Logikschaltung 40. Eine Abfrageleitung 41 dient der externen Kontrolle der eingespeicherten Daten. Es ist aber auch möglich, den Zentralspeicher als externes Gerät auszubilden, dessen Daten über entsprechende Anschlüsse den einzelnen Zwischenspeichern zugeführt werden.

Bezugszeichenliste

| | |
|---|---|
| 1,2 | = Sprechadern |
| 3 | = Zenerdiode |
| 4 | = Gabelschaltung |
| 5 | = Nachbildungskondensator |
| 6 | = Stelleinrichtung |
| 6',12',13',15'<br>17',20',24',28'<br>30',33',38' | = Stellwert-Zwischenspeicher |
| 7 | = Zentralspeicher |
| 8,26,34,36 | = Kondensator |
| 9 | = Versorgungsgerät |
| 10 | = Strommeßwiderstand |
| 11 | = Stabilisator |
| 12,13,15,17,20,<br>24,28,30,33,38 | = Stellglied |
| 14 | = Signalgeber |
| 16 | = Widerstand |
| 18,32 | = Leitung |
| 19,21 | = Verstärker |
| 22 | = Schallgeber |
| 23 | = Mikrofon |
| 25 | = Schalter |
| 27 | = Mikrofonverstärker |
| 29 | = Potentiometer |
| 31 | = Umschalter |
| 35 | = Mehrfrequenz-Wahlsignalgeber |
| 37 | = Wahlsignalverstärker |
| 39 | = Datenbus |
| 40 | = Logikschaltung |
| 41 | = Abfrageleitung |

## Ansprüche

Schaltungsanordnung mit stellbaren Verstärkern für Mikrofone, Hörer, Lautsprecher, Wahlsignalgeber od. dgl. und bzw. oder stellbaren oder simulierten Widerständen für Impedanzanpassung, Filterfunktionen, Einrichtungen zur Frequenzkorrektur oder zur Driftkompensation od. dgl., in Anwendung bei Fernsprechgeräten und Fernsprechanlagen bzw. -geräten, die an Fernsprechleitungen od. dgl. angeschaltet betrieben werden, mit stellbaren Verstärkern und passiven Bauelementen, die in Abhängigkeit von binär codierten Stellwert-Datenworten digital einstellbar sind,
**dadurch gekennzeichnet,** daß die Stellwert-Datenworte in zugeordnete, über die Sprechadern (1,2) mit Strom versorgte Stellwert-Zwischenspeicher (6´,12´,13´...) einlesbar und dort flüchtig oder nicht flüchtig speicherbar sind und daß alle Stellwert-Zwischenspeicher (6´,12´,13´...) an zugeordnete Speicherplätze eines nichtflüchtigen Zentralspeichers (7) angeschlossen oder selbst als Bestandteile des nichtflüchtigen Zentralspeichers ausgebildet sind, in den die für die einzelnen Zwischenspeicher (6´,12´,13´...) vorgesehenen Stellwert-Datenworte aus einem externen Datengeber mittels eines seriellen Datenbusses (39) einlesbar sind und daß alle stellbaren Verstärker (19,27,37) und Widerstände (6,12,13...) samt ihren zugeordneten Zwischenspeichern (6´,12´,13´...) mit ihrer aus den Sprechadern (1,2) gespeisten Stromversorgungseinrichtung (9) sowie entweder der Zentralspeicher (7) selbst oder die Anschlüsse für einen externen Zentralspeicher mit allen Verbindungsleitungen (18,32) und Umschalteeinrichtungen (25,31) in einem einzigen in integrierter Schaltkreistechnik ausgeführten Bauteil zusammengefaßt sind.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | ELEKTRONIK, Band 32, Nr. 19, 23. September 1983, Seiten 118-130, München, DE; H. LEMME: "ICs für die Fernsprechtechnik"<br>* Seite 126, Zeile 20 - Seite 128, Zeile 7 * .<br>--- | 1 | H 03 G 3/00<br>H 04 M 1/57 |
| A | WO-A-8 001 632 (SOCIETE INTERNATIONALE)<br>* Figur 1; Seite 1, Zeile 19 - Seite 2, Zeile 18; Seite 3, Zeile 1 - Seite 4, Zeile 15; Ansprüche 1-3,5-7 *<br>--- | 1 | |
| A | GB-A-2 146 191 (THE GENERAL ELECTRIC CO.)<br>* Insgesamt *<br>--- | 1 | |
| A | E.D.N. ELECTRICAL DESIGN NEWS, Band 28, Nr. 20, 29. September 1983, Seiten 143-148, Boston, Massachusetts, US; L. SHERMAN: "Monolithic digital gain sets provide precise network control"<br>* Der ganze Artikel *<br>--- | 1 | **RECHERCHIERTE SACHGEBIETE (Int. Cl.4)**<br><br>H 03 G<br>H 04 M |
| D,A | DE-A-3 642 828 (TOEPHOLM & WESTERMANN APS)<br>* Insgesamt *<br>----- | 1 | |

Der vorliegende Recherchenbericht wurde für alle Patentansprüche erstellt

| Recherchenort | Abschlußdatum der Recherche | Prüfer |
|---|---|---|
| DEN HAAG | 26-04-1989 | DECONINCK E.F.V. |